**Europäisches Patentamt**

**European Patent Office**

**Office européen des brevets**

(11) Publication number: **0 125 733**
**A1**

## EUROPEAN PATENT APPLICATION

(21) Application number: **84200673.6**

(22) Date of filing: **10.05.84**

(51) Int. Cl.³: **H 03 K 19/094**
**H 03 K 3/353**

(30) Priority: **13.05.83 NL 8301711**

(43) Date of publication of application:
**21.11.84 Bulletin 84/47**

(84) Designated Contracting States:
**DE FR GB IT**

(71) Applicant: **N.V. Philips' Gloeilampenfabrieken**
**Groenewoudseweg 1**
**NL-5621 BA Eindhoven(NL)**

(72) Inventor: **Feller, Ernst**
**c/o INT. OCTROOIBUREAU B.V. Prof. Holstlaan 6**
**NL-5656 AA Eindhoven(NL)**

(74) Representative: **Faessen, Louis Marie et al,**
**INTERNATIONAAL OCTROOIBUREAU B.V. 6 Prof.**
**Holstlaan**
**NL-5656 AA Eindhoven(NL)**

(54) Complementary IGFET circuit arrangement.

(57) The invention relates to CMOS logic circuits which comprise inverters and which are made compatible to logic signals at TTL level. The logic circuit according to the invention can be connected selectively (controlled by the output voltage of this circuit) to different supply voltages, as a result of which in fact two switching levels are obtained. The logic circuit thus obtains a Schmitt trigger behaviour. Further, the CMOST inverter of the logic circuit can now be constructed substantially symmetrically so that a better (quicker) switching behaviour is obtained and the values of the switching currents can be kept limited with respect to asymmetrical CMOST inverters.

FIG.2d

0125733

"Complementary IGFET circuit arrangement"

The invention relates to a voltage level adaptive circuit arrangement comprising an inverting logic gate circuit of complementary insulated gate field effect transistors, which transistors are arranged between a first and a second supply voltage tapping point, which gate has an output and at least one input.

Inverting logic gate circuits of complementary field effect transistors (IGFET's or MOSFET's) are known per se (see, for example, the book "MOS/LSI-Design and Application", pages 113-115, published in 1972 by McGraw-Hill Book Company) and are frequently used. Therefore, it is of frequent occurrence that such inverting gate circuits receive control signals which are supplied by the Transistor-Transistor-Logic (TTL) circuits which are also frequently used. The input of the inverting gate circuit therefore should be suitable for the logic TTL signals (low or "0" level $V_{IL}$ = 0.8 V and high or "1" level $V_{IH}$ = 2.0 V) and therefore the transistors of the complementary inverting logic gate circuit should be constructed very asymmetrically. Although the switching level of the gate circuit is then adapted to the switching level of TTL circuits, the aforementioned solution has a few disadvantages, such as: the still comparatively large spread in the switching levels due to spread in the transistor parameters, a high current during change-over with high input signals ($V_{IH}$ = 2.0 V) and longer delay times with respect to symmetrically constructed inverting gate circuits.

The invention has for its object to provide a complementary IGFET circuit arrangement, in which at high switching speeds a signal level adaptation takes place, which is constructed substantially symmetrically, has a low current consumption both at low and at high switching levels, has a small spread in switching levels and has a Schmitt trigger characteristic. Due to the substantially symmetrical design of the inverting gate circuit, the same or a shorter signal delay can be realized with respect to the logic gate circuits known per se.

A voltage level adaptive circuit arrangement according to the invention is characterized in that the circuit arrangement comprises transistor means which are connected to the second supply voltage tapping point for optionally supplying one of two different supply voltages to the second voltage supply tapping point, which transistor means are provided with a control input which is coupled to the output of the logic gate circuit for choosing the voltage to be supplied to the second voltage supply tapping point in dependence upon the output voltage at the output of the logic gate circuit. When according to the invention the inverting logic gate circuit is connected in series with the transistor means to a supply source and when the output signal of the gate circuit is caused to actuate these transistor means, the possibility is obtained of adapting the switching levels of the gate circuit to the signal levels of the input signals supplied to the input of the gate circuit.

The invention will be described more fully with reference to examples shown in the accompanying drawings, in which:

Figure 1 shows an example of a CMOST logic circuit known from the prior art,

Figures 2a, b, c and d show simple logic circuits for explanation of the invention, and

Figures 3a, b and c are graphs illustrating switching characteristics of the circuit arrangements of Figures 2a, b and c.

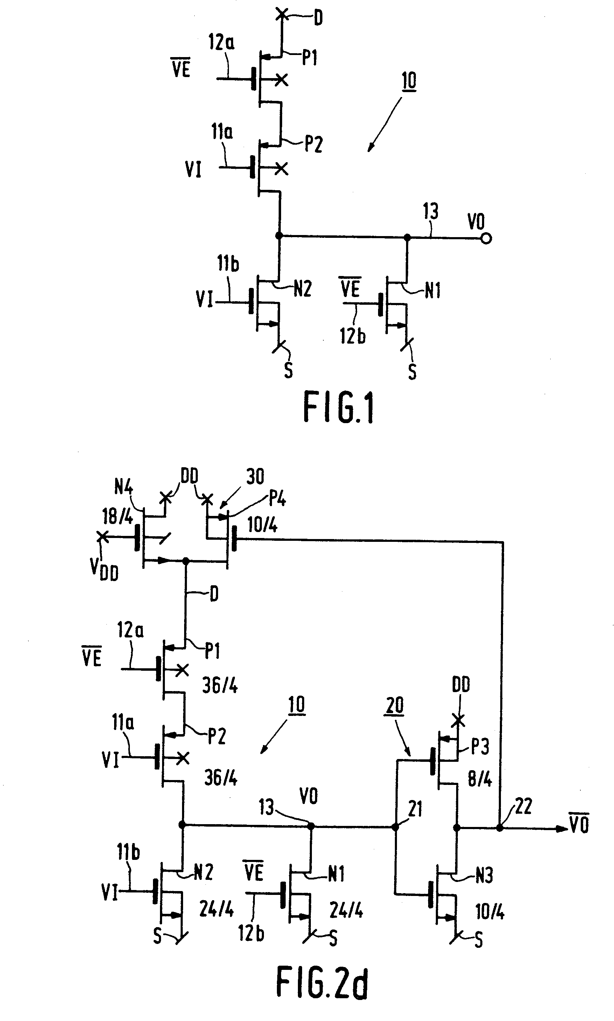

Figure 1 shows a logic (NOR) gate circuit 10 which receives two input signals VI and $\overline{VE}$ at input terminals 11a, b and 12a, b respectively, and emits an output signal VO at the output terminal 13. The NOR gate is connected to a supply source (not shown) via supply source terminals D and S. The supply terminal D receives a supply voltage $V_{DD}$ (+5 V) and the terminal S receives a supply voltage $V_{SS}$ (0 V). The NOR gate 10 is composed of complementary insulated gate field effect transistors P1, P2, N1 and N2, preferably of MOS transistors, of which the transistors P1 and P2 are of the so-called P-type and the transistors N1 and N2 are of the N-type. The transistors N2 and P2 constitute a CMOS inverting circuit and receive at their gates the input signal VI via the input terminals 11a, b. The gate circuit 10 will be able to respond to an input signal VI only when the second input signal $\overline{VE}$ (chip-enabling signal $\overline{VE}$) is "low", as a result of which the transistor P1 becomes conducting and the transistor N1 is cut off.

If such a CMOS circuit has to be controlled by signals on TTL level (high level 2.0 V; low level 0.8 V) produced by TTL circuits, the circuit arrangement should be constructed very asymmetrically, which has the following disadvantages:

a.      a large spread in switching levels which is caused by the spread in transistor parameters;

b.      the occurrence of comparatively large currents in circuit arrangements at high input levels ($V_{IH} = 2.0$ V);

c.      the occurrence of a longer switching delay then in symmetrically constructed gate circuits.

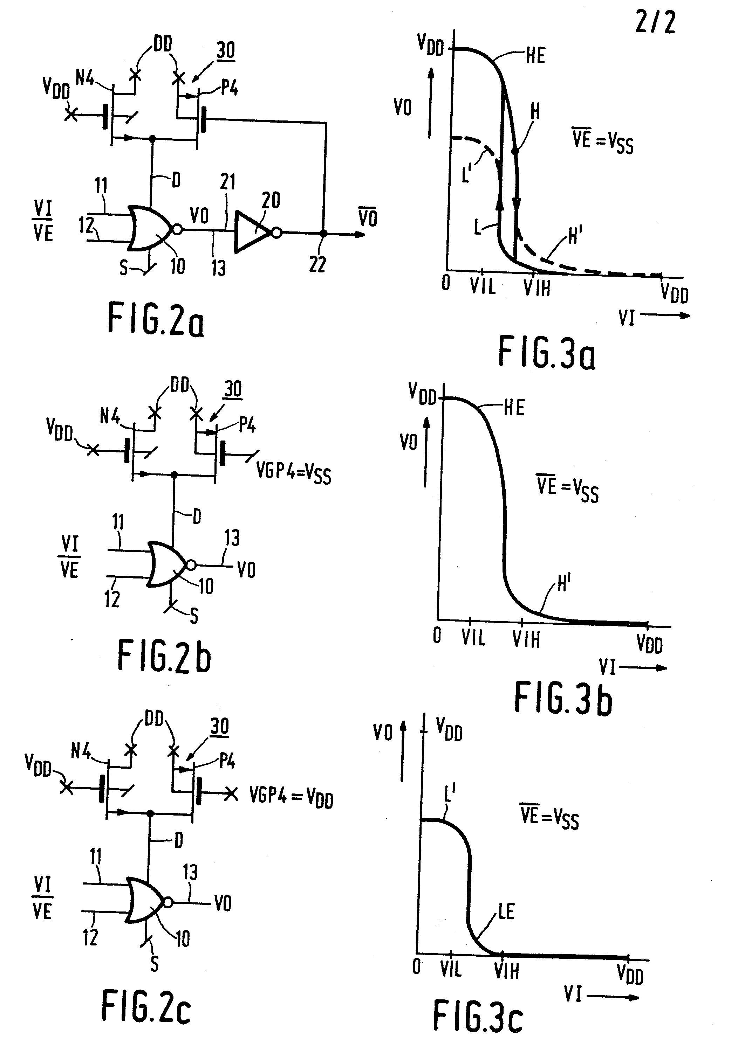

According to the invention, the output signal of the inverting gate circuit is used to adapt the supply voltage to be applied to the gate circuit to the voltage levels of the input signals. Figure 2a shows an embodiment of a circuit arrangement according to the invention. The supply voltage tapping point D is connected to main electrodes of the transistor means 30, the further main electrodes of which are connected to a supply source connection terminal DD. A first transistor N4 of the means 30 is of the N-type and has a gate electrode which is connected to the terminal DD. A second transistor P4 of the means 30 is of the P-type and its gate is connected
to the output 22 of the inverting circuit 20. The means
30 are controlled via the inverting circuit 20 by the
signal VO at the output 13 of the gate circuit 10, for
which purpose the output 13 of the logic gate circuit 10
is connected to an input of a second CMOST inverting
circuit 20.

The object of the operation of the inverting
circuit 20 and the transistor means 30 will be explained
more fully with reference to Figures 2a, b and c and
Figures 3a, b and c. The logic gate circuit 10 is a NOR
gate and therefore the output signal VO at the output 13
is "high" if the input signals VI and $\overline{VE}$ are both "low".
Starting from this situation, the output voltage would
fall from "high" to "low" if the input signal VI rises
from "low" to "high". As long as the input signal VI is
at the "low" TTL level (0.8 V), the output signal $\overline{VO}$ at
the output terminal 22 of the inverting circuit 20 will
also be "low" ($= V_{SS}$). Therefore,  the transistor P4 is
fully conducting and the supply voltage tapping point D
of the gate circuit 10 is increased to the voltage $V_{DD}$.
If the voltage at the gate of the transistor P4 is
continuously held at the potential $V_{SS}$, as indicated in
Figure 2b, the voltage VO will decrease from $V_{DD}$ to zero V,
as is shown in Figure 3b, if the input signal VI at the
input terminal 11 of the gate circuit 10 increases from
zero V to $V_{DD}$. In this situation (VI $= \overline{VO} = V_{DD}$ and
VO = zero), the connection between the output 22 of the
inverting circuit 20 and the gate of the transistor P4
will cause the latter transistor to be cut off. The
voltage tapping point D is then connected via the
transistor N4 to the supply voltage $V_{DD}$. The transistor
N4 is connected as a load transistor. Since the transistor
P4 is not in the conducting condition, the voltage at
the tapping point D will no longer be increased to the
voltage $V_{DD}$.

If the voltage at the gate of the transistor P4 is continuously held at the potential $V_{DD}$, as is shown in Figure 2c, the voltage at the tapping point D will be lower than the voltage at the tapping point D in Figure 2b. Therefore, by decreasing input voltage VI and $V_{DD}$ to zero V, the output voltage VO will increase from zero V to a value considerably lower than the voltage $V_{DD}$ (this value can be adjusted by the transistor N4). The voltage at the gate of the transistor P4 is not kept constant, however, because the voltage $\overline{VO}$ (see Figure 2a) decreases from $V_{DD}$ to $V_{SS}$ in dependence upon the output voltage VO at the output terminal 13. Initially, $\overline{VO}$ is equal to $V_{DD}$ and the transistor P4 is in the cut-off condition. If the input voltage VI decreases and as long as the transistor P4 is cut off, the output voltage VO will initially vary (increase) according to the curve LE, as is shown in Figure 3c. However, as soon as the input voltage VI has fallen below $V_{IH}$ and decreases further to $V_{IL}$, the output voltage VO will increase to such a level (1 V < VO < 2 V) that the output voltage $\overline{VO}$ at the output 22 decreases to such a level that the transistor P4 becomes conducting. This results in that the output voltage VO is increased to a slightly higher level, which of course leads to a further decrease of the output voltage $\overline{VO}$ of the inverter 20. Due to this cumulative phenomenon (regenerative feedback), the voltages VO and $\overline{VO}$ will continuously influence each other until $\overline{VO}$ has decreased to such a level that the transistor P4 is fully conducting. This means that the output voltage VO is increased at a given input voltage VI (in this example 1.2 V) between $V_{IL}$ and $V_{IH}$ from the level on the curve LE in Figure 3c to a level on the curve HE of Figure 3b. Figure 3a shows the curve L which follows the output voltage VO and which is composed of the low end LE and the high end HE of the curves of Figures 3c and 3b, respectively. Figure 3a indicates a further part L' of the curve of Figure 3a (by a broken line) to illustrate the influence of the selection of voltages which are applied to the voltage tapping point D.

Taking the aforementioned facts into account, it can be simply recognized what will happen in the circuit arrangement shown in Figure 2a if the input voltage VI increases from $V_{SS}$ to $V_{DD}$. Initially, the output voltage VO will follow the high end portion HE of the curve shown in Figure 3b because the transistor P4 is fully conducting. The input voltage VI increases to a level above $V_{IL}$, which results in that the voltage VO will decrease from $V_{DD}$ to a lower value according to the curve HE (Figure 3b). The input voltage VI further increases to, for example, 1.6 V and the output voltage VO will decrease to below 2 V. At this output voltage VO, the voltage $\overline{VO}$ at the output 22 of the inverter 20 will increase to such a level that the transistor P4 becomes less strongly conducting. This results in that the output voltage VO decreases still further. Also in this case, the variations of the voltages VO and $\overline{VO}$ will have a cumulative effect one on the other until the transistor P4 is fully cut off. This means that the voltage VO has fallen from the high end HE of the curve in Figure 3b to the low end LE of the curve in Figure 3c. The resulting switching characteristic H for the voltage VO, with which the input voltage VI increases from 0 V to $V_{DD}$, is shown in Figure 3a. In order to illustrate the gain achieved due to the regenerative feedback, the low end H' of the curve of Figure 3b is indicated by a broken line in Figure 3a.

Due to the different voltage levels at the voltage tapping point D for the gate circuit 10, it is possible that the level of the (increasing) input voltage VI, at which the output voltage VO decreases from high to low, is higher than the level of the (decreasing) input voltage VI, at which the output voltage increases from low to high. The gate circuit therefore has obtained a Schmitt trigger characteristic.

Figure 2d shows in detail the circuit arrangement of Figure 2a. The NOR gate <u>10</u> is identical to the NOR gate shown in Figure 1, although the P-type and N-type transistors of the gate 10 in Fig. 2d are constructed more symmetrically than the transistors in Figure 1 if the latter circuit is TTL-compatible. The inverting circuit 20 comprises two CMOS transistors P3 and N3, whose gates are connected to the input 21, which is connected to the output 13 of the NOR gate 10. The output 22 of the inverting circuit 20 is connected to the gate of the transistor P4 (P-type MOS transistor) of the transistor means 30. The transistor means 30 comprise a further transistor N4 (N-type MOS transistor), whose main electrodes are connected parallel to the main electrodes of the transistor P4. The gate of the transistor N4 is connected through the supply source connection terminal DD to the supply voltage $V_{DD}$ so that the transistor N4 acts as a load transistor.

As will be appreciated, the invention is not limited to the embodiments described above, but can be used in principle in any complementary (insulated gate) field effect transistor circuit arrangement comprising inverting logic circuits, such as NAND, NOR ...

CLAIMS

1.      A voltage level adaptive circuit arrangement comprising an inverting logic gate circuit of complementary insulated gate field effect transistors, which transistors are arranged between a first and a second voltage supply tapping point, which gate has an output and at least one input, characterized in that the circuit arrangement comprises transistor means which are connected to the second supply voltage tapping point for optionally supplying one of two different supply voltages to the second supply voltage tapping point, which transistor means are provided with a control input which is coupled to the output of the logic gate circuit for choosing the voltage to be supplied to the second supply voltage tapping point in dependence upon the output voltage at the output of the logic gate circuit.

2.      A circuit arrangement as claimed in Claim 1, characterized in that the transistor means comprise a first and a second transistor, which are of complementary types and whose main electrodes are connected parallel to each other between the second supply voltage tapping point and a supply source connection terminal, the gate of the first transistor being connected to the supply voltage connection terminal and the gate of the second transistor constituting the control input of the transistor means.

3.      A circuit arrangement as claimed in Claim 2, characterized in that the first transistor is an N-type insulated gate field effect transistor and the second transistor is a P-type insulated gate field effect transistor.

4.      A circuit arrangement as claimed in Claim 2 or 3, characterized in that the output of the logic gate circuit is connected _via_ a second inverting circuit to the control input of the transistor means.

5.        A circuit arrangement as claimed in Claim 4, characterized in that the second inverting circuit is composed of two complementary insulated gate field effect transistors, the second inverting circuit being connected between the supply voltage connection terminal and the first supply voltage tapping point.

FIG.1

FIG.2d

FIG.2a

FIG.3a

FIG.2b

FIG.3b

FIG.2c

FIG.3c

# EUROPEAN SEARCH REPORT

European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| Y | US-A-4 032 795 (HALE) <br> * Figures 1-3; column 1, line 61 - column 2, line 65 * | 1-3 | H 03 K  19/094 <br> H 03 K   3/356 |
| Y | US-A-3 911 289 (TAKEMOTO) <br><br> * Figures 3A,6; column 3, line 26 - column 4, line 58 * | 1,2,4, 5 | |
| Y | PATENTS ABSTRACTS OF JAPAN, vol. 3, no. 143 (E-154), 27th November 1979, page 17 E 154; & JP - A - 54 121 051 (NIPPON DENKI K.K.) 19-09-1979 <br> * Figure * | 1-5 | |
| A | PATENTS ABSTRACTS OF JAPAN, vol. 6, no. 164 (E-127)[1042], 27th August 1982; & JP - A - 57 81 728 (TOKYO SHIBAURA DENKI K.K.) 21-05-1982 <br> * Abstract; figure * | 1,2,4 | TECHNICAL FIELDS SEARCHED (Int. Cl. ³) <br><br> H 03 K |
| A | PATENTS ABSTRACTS OF JAPAN, vol. 5, no. 109 (E-65)[781], 15th July 1981; & JP - A - 56 48 725 (SUWA SEIKOSHA K.K.) 02-05-1981 <br> * Abstract; figure * | 1-5 | |
| | ---     -/- | | |

The present search report has been drawn up for all claims

| Place of search <br> THE HAGUE | Date of completion of the search <br> 21-08-1984 | Examiner <br> FEUER F.S. |
|---|---|---|

**European Patent Office**

## EUROPEAN SEARCH REPORT

| | DOCUMENTS CONSIDERED TO BE RELEVANT | | Page 2 |
|---|---|---|---|
| Category | Citation of document with indication, where appropriate, of relevant passages | Relevant to claim | CLASSIFICATION OF THE APPLICATION (Int. Cl. ³) |
| A | PATENTS ABSTRACTS OF JAPAN, vol. 7, no. 80 (E-168)[1225], 2nd April 1983, page 7 E 168; & JP - A - 58 6620 (TOKYO SHIBAURA DENKI K.K.) 14-01-1983 * Abstract; figure * | 1-5 | |
| A | US-A-3 755 690 (SMITH) | 1 | |
| A | ELECTRONICS, vol. 48, no. 15, 24th July 1975, pages 102-106, New York, US; S. HUME: "Consider 1,024-bit C-MOS RAMs for small static-memory systems" * Figure 5b * | 1,4 | |
| A | US-A-3 728 556 (ARNELL) | 1,4 | |
| A | FR-A-2 480 531 (LE MATERIEL TELEPHONIQUE THOMSON-CSF) | 1 | TECHNICAL FIELDS SEARCHED (Int. Cl. ³) |
| A | US-A-3 904 888 (GRIFFIN et al.) | 1 | |
| P,X | US-A-4 437 024 (WACYK) * Figure 2; column 1, line 18 - column 5, line 55 * | 1-5 | |

The present search report has been drawn up for all claims

| Place of search THE HAGUE | Date of completion of the search 21-08-1984 | Examiner FEUER F.S. |
|---|---|---|

EPO Form 1503. 03.82